# EUROPÄISCHE PATENTSCHRIFT

(11) **EP 0 755 571 B1**
(45) Veröffentlichungstag und Bekanntmachung des Hinweises auf die Patenterteilung: **31.10.2001**
(21) Anmeldenummer: 94917638.2
(22) Anmeldetag: 17.05.1994
(51) Int. Cl.: H01L 21/00

(54) **VERFAHREN UND VORRICHTUNG ZUR CHEMISCHEN BEHANDLUNG VON SUBSTRATEN**
PROCESS AND DEVICE FOR CHEMICALLY TREATING SUBSTRATES
PROCEDE ET DISPOSITIF DE TRAITEMENT CHIMIQUE DE SUBSTRATS

(30) Priorität: 15.04.1994 DE 4413077
(43) Veröffentlichungstag der Anmeldung: 29.01.1997
(73) Patentinhaber: STEAG MicroTech GmbH, 72124 Pliezhausen (DE)
(72) Erfinder: SCHILD, Robin, D-78052 Villingen-Schwenningen (DE); KOZAK, Milan, D-78183 Hüfingen (DE); DURST, Johann, D-78166 Donaueschingen (DE)
(74) Vertreter: Wagner, Karl H., Dipl.-Ing.
(86) Internationale Anmeldenummer: EP9401585
(87) Internationale Veröffentlichungsnummer: WO9528736

(56) Entgegenhaltungen:
- EP-A- 0 328 746
- EP-A- 0 385 536
- WO-A-92/12533
- WO-A-94/03284
- US-A- 4 722 752
- US-A- 5 275 184
- PATENT ABSTRACTS OF JAPAN vol. 9, no. 332 (E-370) (2055) 26. Dezember 1985 & JP,A,60 163 435 (TOSHIBA) 26. August 1985

## Beschreibung

Die Erfindung betrifft ein Verfahren zur chemischen Behandlung von Substraten, bei dem wenigstens ein Substrat nacheinander einer chemischen Behandlung, einem Spülvorgang und einem Trocknungsvorgang unterzogen wird bzw. eine Vorrichtung zur oben beschriebenen chemischen Behandlung.

Heutzutage weist eine automatische Naßbank eine Reihe von Becken oder Tanks für eine Abfolge chemischer Naßprozesse auf. Nach Abschluß einer gewissen chemischen Prozeßfolge wird ein Substrat, zum Beispiel ein Siliziumwafer, in ein separates Spül- bzw. Rinsebecken, getaucht und anschließend getrocknet.

Das Trocknen eines Substrats kann beispielsweise mittels einer Zentrifuge erfolgen, aber auch während des langsamen Herausfahrens des Substrats aus dem Spülbecken.

Aus der EP-O 385 536 ist der sogenannte "Marangoni-Trockner" bekannt. Bei dem in diesem Patent beschriebenen Verfahren wird zusätzlich zum langsamen Herausfahren des Substrats aus einem Bad ein Dampf auf das Substrat angewendet, wobei der Dampf nicht auf dem Substrat kondensiert, aber in die Flüssigkeit diffundiert. Am Flüssigkeits-Meniskus auf der Substratoberfläche entsteht ein Konzentrationsgradient und damit ein Oberflächen-spannungsgradient. Dieser Gradient erzeugt eine Flüssigkeitsbewegung vom Substrat weg in die Flüssigkeit (Marangoni-Effekt) und bewirkt ein rückstandsfreies Trocknen des Substrats.

Bei der aus der EP-0 385 536 bekannten Vorrichtung werden die Substrate während des Trocknungsvorgangs mit einem Messer aus der Flüssigkeit herausgehoben und in eine Hilfskassette oberhalb des Beckens geschoben und dort von dem Messer in dieser Lage gehalten, bis die sich im Behälter noch befindliche Kassette ebenfalls aus der Flüssigkeit herausbewegt hat, um danach die Wafer wieder aufzunehmen. Die Trocknung der Kassette ist jedoch schwierig und sehr zeitaufwendig, da große Flächen zu trocknen sind und insbesondere die Flüssigkeit in den Führungsnuten für die Substrate aufgrund der Kapillarwirkung sehr lange haften bleibt und diese Nuten schwer zu trockenen sind. Der Trocknungsvorgang erfordert daher bei dieser Vorrichtung viel Zeit, so daß die damit erreichte Produktivität gering ist.

Aus dem US-Patent 4,722,752 ist eine Vorrichtung und ein Verfahren bekannt, um Wafer zu spülen und zu trocknen, wobei sich die Wafer in einer Kassette befinden. Die Wafer werden getrennt von den Kassetten langsam aus dem Spülbecken entfernt und anschließend in die ebenfalls langsam herausgefahrenen, getrockneten Kassetten eingesetzt.

Die beschriebenen Vorrichtungen bzw. Verfahren weisen folgende Nachteile auf: Das Spülbecken ist in jedem Fall ein von den restlichen Prozeßbecken abgetrenntes Becken und dient ausschließlich zum Spülen der Substrate. Ein eigenes Spülbecken bedeutet aber einen erhöhten Raum- bzw. Platzbedarf. Außerdem muß das Substrat vor dem Spülschritt durch die Oberfläche eines Fluids für die chemische Behandlung an die Luft und danach wieder in das Spülfluid, was bekannterweise nachteilige Folgen für die Partikelkontamination des Substrats haben kann. Dies trifft besonders auf hydrophobe Oberflächen (zum Beispiel nach HF-Behandlung) zu. Ebenfalls kann das Einsetzen bzw. Herausnehmen von Substraten in bzw. aus verschiedenen Becken für die chemische Behandlung bzw. den Spülschritt einen erhöhten Zeitaufwand bedeuten. Ebenfalls ist bei den bekannten Vorrichtungen bzw. Verfahren immer eine Kassette (carrier) zur Handhabung der Substrate erforderlich.

Aus der US-A-5 275 184 ist eine Vorrichtung zum Behandeln von Wafern bekannt, bei der die Wafer sowohl während des Fluid-Behandlungsvorgangs als auch während des Trocknungsvorgangs in einer Behandlungskammer mit Unterdruck in einem Wafer-Anhebmechanismus liegen. Daher gelten die zuvor im Zusammenhang mit der US-A-4 722 752 beschriebenen Nachteile auch hier, da die Wafer während des Trocknungsvorgangs im Wafer-Anhebmechanismus liegen und die Trocknung daher nicht optimal erfolgt. Der Trocknungsvorgang läuft dabei auch langsamer ab, weil zusätzlich zu den Wafern die Anhebvorrichtung getrocknet wird bzw. werden muß. Eine kassetten-freie Behandlung der Substrate während des Trocknungsvorgangs ist daher nicht möglich.

Aus der WO-A-9 212 533 ist eine Vorrichtung zum Trocknen von Substraten bekannt, bei der die Substrate sowohl während des Spül- bzw. Behandlungsvorgangs als auch während des Trocknungsvorgangs in einer Kassette angeordnet sind. Insofern weist diese Vorrichtung dieselben Nachteile wie die zuvor genannten bekannten Vorrichtungen auf. Der Behälter wird sowohl während des Reinigungs- als auch während des Trocknungsvorgangs mittels eines Deckels geschlossen gehalten. Über eine Einlaßleitung im oberen Bereich des Behälters wird nach Absaugung inertes Gas eingeleitet, welches an die Stelle der Reinigungsflüssigkeit tritt, die nach dem Reinigungsvorgang abgelassen wird.

Der Erfindung liegt daher die Aufgabe zugrunde, ein Verfahren zur chemischen Naßbehandlung bzw. eine Vorrichtung für dieses Verfahren anzugeben bzw. zu schaffen, das den Prozeßablauf in einer automatischen Naßbank rationalisiert, d. h. Zeit und Raumbedarf einspart. Eine weitere Aufgabe der Erfindung besteht darin, die Verunreinigung der Substrate während einer derartigen Abfolge von chemischen Naßprozessen möglichst gering zu halten. Schließlich ist eine weitere Aufgabe der Erfindung die Möglichkeit, auf eine Kassette o.ä. zur Halterung der Substrate bzw. im Zusammenhang mit dem Einsetzen bzw. Ausfahren der Substrate in bzw. aus dem Becken zu verzichten.

Die gestellte Aufgabe wird erfindungsgemäß durch die Merkmale des Anspruches 1 gelöst. Eine Kassette o.ä. ist daher nicht erforderlich.

Vorteilhafterweise wird die chemische Behandlung und der Spülvorgang in demselben Becken dadurch realisiert, daß ein Fluid zur chemischen Behandlung durch ein weiteres derartiges Fluid ergänzt bzw. (teilweise) ersetzt und/oder durch ein Spülfluid ersetzt wird. Bevorzugterweise wird in einem sequentiellen chemischen Prozeß vor dem Ersetzen des Fluids zur chemischen Behandlung durch ein weiteres derartiges Fluid zunächst ein Spülfluid eingeleitet und das Substrat bzw. die Substrate aus dem Bekken entfernt und dabei gleichzeitig getrocknet. Anschließend wird das Spülfluid durch ein weiteres Fluid zur chemischen Behandlung ersetzt und das Substrat wieder in das Becken eingefahren.

Bei der Erfindung geschieht der Trocknungsvorgang während des Entfernens des Substrats aus dem Spülfluid. Dies beinhaltet gewöhnlicherweise ein sehr langsames Herausfahren des Substrats aus dem Spülfluid.

Um diesen Vorgang effizient zu machen, wird ein Dampf auf das Substrat angewendet, der nicht auf dem Substrat kondensiert und sich mit dem Spülfluid mischt. Das Gemisch besitzt eine geringere Oberflächenspannung als das Spülfluid, was bedeutet, daß es eine Kraft gibt, die das auf dem Substrat haftende Spülfluid in das Becken zurückdrängt.

Das Ersetzen des Fluids zur chemischen Behandlung durch das Spülfluid geschieht in einem bevorzugten Ausführungsbeispiel durch Verdrängen. Ein Ableiten z.B. des Fluids zur chemischen Behandlung und ein anschließendes Zuleiten des Spülfluids hätte eine Aussetzung des Substrats einer erhöhten Partikelkontamination in der Luft zur Folge. Das Verdrängen des einen Fluids durch das andere, z.B. das Spülfluid hat zum Vorteil, daß das Substrat keine Phasengrenze durchdringen muß und der Luft nicht ausgesetzt wird. Selbstverständlich können auch mehrere Fluids zur chemischen Behandlung vor dem Spülvorgang durch Verdrängen einander ersetzen. Insbesondere im Zusammenhang mit dem Ersetzen eines Fluids zur chemischen Behandlung durch ein weiteres derartiges Fluid, kann das Ersetzen auch ein teilweises Ersetzen, also ein Mischen beinhalten.

Bevorzugterweise wird das Spülfluid in das Becken eingeleitet und gleichzeitig das Gemisch aus Fluid zur chemischen Behandlung und dem Fluid abgeleitet.

Das Einleiten des Spülfluids und das Ableiten des Fluids zur chemischen Behandlung erfolgt vorzugsweise an verschiedenen Stellen des Beckens. Dadurch wird beispielsweise das Ersetzen des einen Fluids durch das andere zeitlich optimiert.

Das Einleiten des Spülfluids geschieht bevorzugterweise vom Boden des Beckens aus, während das Ableiten des Gemisches durch Überlaufen erfolgt. Für das Ableiten ist somit keine zusätzliche Pumpeinrichtung nötig. Durch das Einleiten vom Beckengrund, d.h. weit entfernt vom Ort des Ableitens, wird möglichst wenig von dem eingeleiteten Spülfluid abgeleitet. Ebenfalls in Hinblick auf die Erdanziehung kann dies, evtl. mit zusätzlichen Temperaturgradienten, vorteilhaft sein. Dies ist ökonomisch vorteilhaft und zeitsparend.

In einem bevorzugten Ausführungsbeispiel der Erfindung ist das Fluid zur chemischen Behandlung verdünnte Flußsäure. Eine Behandlung in verdünnter Flußsäure (HF) dient dazu, die Oxidschicht auf einer Substratoberfläche zu entfernen und eine für manche Folgeprozesse notwendige hydrophobe, Wasserstoff-passivierte Oberfläche zu erhalten.

In einem weiteren bevorzugten Ausführungsbeispiel der Erfindung ist das Fluid zur chemischen Behandlung Ozon. Eine Behandlung mit Ozon wird dann durchgeführt, wenn beabsichtigt wird, auf einer, zum Beispiel aus Reinigungsgründen mit HF behandelten (hydrophoben) Substratoberfläche wieder ein chemisches Oxid aufwachsen zu lassen und somit eine hydrophile Oberfläche zu erzeugen.

Bei dem Verfahren wird zum Ein- und/oder Herausfahren von wenigstens einem Substrat in bzw. aus einem Becken, das Substrat im Becken durch ein Messer einer Aufnahmevorrichtung ein- und/oder herausgefahren.

Ein Vorteil der Erfindung besteht darin, daß auf eine Kassette als Halter für die Substrate bzw. zum Ein- bzw. Ausfahren der Substrate verzichtet werden kann. Das erfindungsgemäße Verfahren kommt somit ohne Carrier aus. Dadurch werden die bekannten Nachteile eines Carriers im Zusammenhang mit einem Trocknungsschritt (kein Trocknen an den Berührungsstellen Carrier-Substrat) vermieden. Die erfindungsgemäße Aufnahmevorrichtung ist kein Carrier sondern lediglich eine ein- und ausfahrbare Auflage für ein oder mehrere Substrat(e). Eine carrierlose Trocknung spart nicht nur den Schritt des Trocknens eines Carriers ein, sondern reduziert hinsichtlich des Spülvorgangs, die Spülzeit aber auch den Verbrauch an Spülfluid. Ebenfalls wird des Verschleppen von Chemikalien in den Trockner durch die carrierlose Prozeßführung verringert.

Vorteilhafterweise besteht die Aufnahmevorrichtung aus einer zweiteiligen Auflagevorrichtung und einem getrennt vertikal bewegbaren Messer.

Das Messer fährt das Substrat so weit aus dem Becken heraus, daß es von den Führungen, die an den gegenüberliegenden Innenseiten einer Haube angebracht sind, geführt bzw. gehalten wird.

Es sind bewegliche Halterungen vorgesehen, die die Substrate nach dem Herausfahren aus dem Becken in ihre Lage über dem Becken in trockenem Zustand halten. Die beweglichen Halterungen unterhalb bzw. in der Haube sind derart ausgebildet, daß, falls die Substrate von den beweglichen Halterungen gehalten werden, die Haube ohne weiteres geöffnet bzw. geschlossen werden kann, ohne die Lage der Substrate zu verändern. Die beweglichen Halterungen sind immer trocken und haben nur mit den bereits getrockneten Substraten Kontakt.

Vorteilhafterweise sieht das erfindungsgemäße Verfahren eine Unterstützung des Spül- bzw. Reinigungsschritts durch Ultra- bzw. Megaschall vor. Vorteilhafterweise sind dazu an dem Becken Piezoelemente vorgesehen, um Schallwellen zur Reinigung der Substrate zu erzeugen. Ein solches "Megasonic"-System ist in diesem Zusammenhang besonders vorteilhaft, da die Partikelkontamination der Substrate in dem erfindungsgemäßen Verfahren auf ein Minimum reduziert wird. Somit wird eine extrem gründliche Reinigung der Substrate erzielt.

Die gestellte Aufgabe wird ebenfalls erfindungsgemäß durch die Merkmale des Anspruches 10 gelöst.

Bevorzugterweise ist zusätzlich zu dem (inneren) Becken an seiner Außenseite ein äußeres Becken vorgesehen, das beispielsweise als Sicherheitsreservoir dient.

Zur Ausrichtung des Beckens im Hinblick auf ein gleichmäßiges Überlaufen des zu ersetzenden Fluids sind vorteilhafterweise Nivellierungsschrauben vorgesehen.

Vorteilhafterweise ist als Einleitvorrichtung ein Diffusor, vorzugsweise am Beckengrund, vorgesehen. Dies ist zum Beispiel für das oben erwähnte Ozon (O₃) sinnvoll.

Im Falle einer Flüssigkeit, wie zum Beispiel verdünnter Flußsäure ist eine Pumpe in Kombination mit einem Einleitmechanismus, ebenfalls vorzugsweise am Beckengrund, vorteilhaft.

Bei der erfindungsgemäßen Vorrichtung befindet sich eine Haube über dem Becken, um das Becken bzw. auch das getrocknete Substrat vor Partikelkontamination zu schützen und um für eine dichte Dampfatmosphäre in dem Bereich oberhalb des Beckens zu sorgen. Zur Einleitung des Dampfes weist die Haube einen integrierten Diffusor, d.h. eine in die Haube integrierte perforierte Diffusorplatte, auf für die Zufuhr bzw. Verteilung eines IPA(Isopropylalkohol)/N₂-Gemisches. Auf diese Weise wird eine homogene und für alle Substrate gleiche Dampfatmosphäre in der Prozeßkammer erzeugt, somit sind die Prozeßbedingungen für jeden Wafer dieselben. Die Mischung des IPA mit dem Stickstoff erfolgt in einer Gaswaschflasche (bubbler).

Das Substrat wird im Becken mittels einer Aufnahmevorrichtung gehalten, die aus einem messerförmigen Teil, dem sogenannten, Messer, und z. B. zwei Auflagevorrichtungen besteht. Vorzugsweise sind das Messer und die Auflagevorrichtungen jeweils relativ zueinander bewegbar und das Messer ist vorteilhafterweise zwischen den beiden Auflagevorrichtungen angeordnet. Die Auflagen sind im Becken vorgesehen, während das Messer auch aus der Flüssigkeit auftauchen kann.

Bei der Erfindung weist die Haube über dem Becken eine Führung für das Substrat auf. Diese ist bevorzugterweise auf der Innenseite der Haube an zwei gegenüberliegenden Seiten befestigt. In dieser Führung kann ein Substrat, wie z.B. ein Siliziumwafer, geführt bzw. gehalten werden.

Die Führung ist an gegenüberliegenden Seiten der Haube befestigt. Sie besitzt eine rillenförmige Form zur Aufnahme von mehreren Substraten. Dadurch kann auf eine Kassette zur Halterung der Substrat verzichtet werden.

Bevorzugterweise ist die Führung in der Haube zweiteilig ausgeführt, wobei mindestens eine Kante der Aufnahme abgeschrägt ist, um das Aufnehmen des Substrats zu erleichtern.

Bevorzugterweise besitzt mindestens ein Teil der Führung eine abgeschrägte Kante, zur leichteren Aufnahme der Substrate. Ebenso vereinfacht sich dadurch das Öffnen bzw. Schließen der Haube.

In einem bevorzugten Ausführungsbeispiel der Erfindung sind bewegliche Halterungen vorgesehen, die unterhalb der Haube und oberhalb des Beckens über das Becken von außen eingefahren werden können, und eine kreisabschnitts-förmige Vertiefung aufweisen. Die beweglichen Halterungen können ebenso wie die Aufnahme in der Haube und auch wie das Ensemble aus Messer und den beiden Auflagevor-richtungen im Becken das Substrat alleine halten. Ruht das Substrat auf den kreisabschnittsförmigen Vertiefungen der beweglichen Halterungen und wird es von der Aufnahme in der Haube fixiert, so kann die Haube ohne Mitführung der Substrate geöffnet werden. Die Substrate werden dann allein von den beweglichen Halterungen gehalten bis der Anlagenhandler sie zur weiteren Verarbeitung davon entfernt.

Die Erfindung sowie weitere Ausgestaltungen und Vorteile derselben wird bzw. werden nachfolgend anhand von Ausführungsbeispielen unter Bezugnahme auf die Figuren erläutert. In der Zeichnung zeigt:
- Fig. 1: eine Querschnittsansicht einer erfindungsgemäßen Vorrichtung;
- Fig. 2: einen ersten Schritt in einem erfindungsgemäßen Prozeßfluß;
- Fig. 3: einen zweiten Schritt in einem erfindungsgemäßen Prozeßfluß;
- Fig. 4: einen dritten Schritt in einem erfindungsgemäßen Prozeßfluß;
- Fig. 5: einen vierten Schritt in einem erfindungsgemäßen Prozeßfluß;
- Fig. 6: einen fünften Schritt in einem erfindungsgemäßen Prozeßfluß;
- Fig. 7: einen sechsten Schritt in einem erfindungsgemäßen Prozeßfluß;
- Fig. 8: einen siebten Schritt in einem erfindungsgemäßen Prozeßfluß;
- Fig. 9: einen achten Schritt in einem erfindungsgemäßen Prozeßfluß.

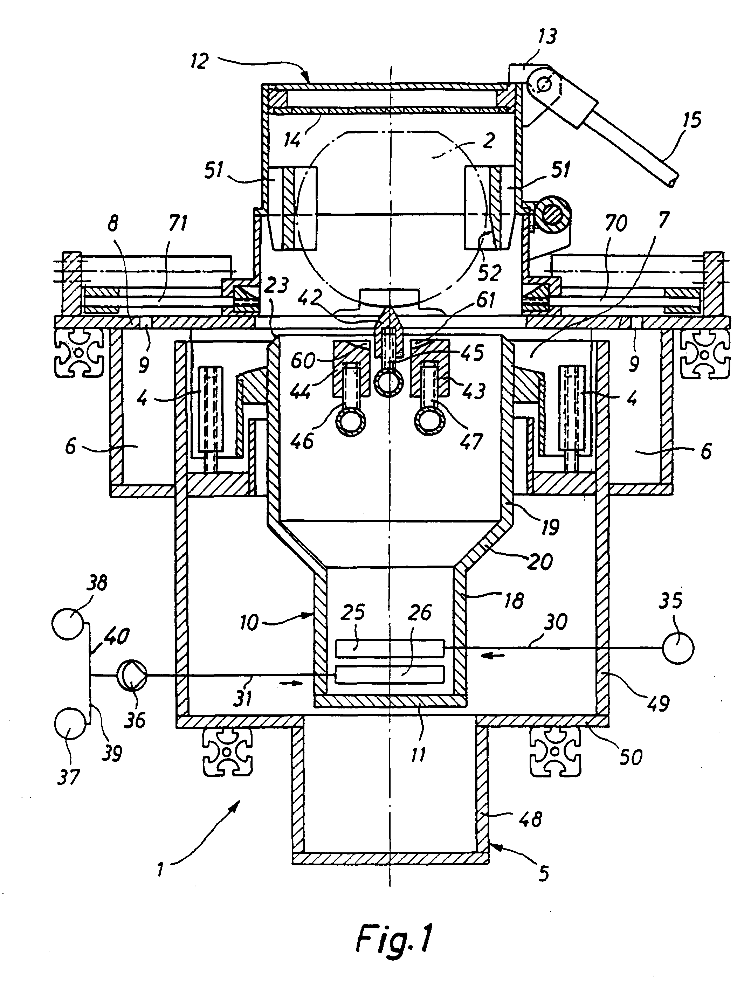

Fig. 1 zeigt eine Vorrichtung zur chemischen Naßbehandlung 1 von Substraten, insbesondere von einem Wafer 2. Die Vorrichtung 1 besteht aus einem äußeren Becken 5 und einem inneren Becken 10. Das äußere Becken 5 weist eine äußere ringförmige Kammer 6 und eine innere ringförmige Kammer 7 auf. Oberhalb des inneren Beckens 10 ist eine Haube 12 mit einem Öffnungsmechanismus 13 zur Abdeckung des inneren Beckens 10 angeordnet. Die Haube 12 weist einen von einer Diffusorplatte 14 begrenzten Raum auf, in den beispielsweise ein IPA/N₂-Gemisch eingeleitet werden kann. Das innere Becken 10 besteht aus einem Schmalzylinder 18 am unteren Ende des inneren Beckens 10. Ein kegelstumpfförmiger Zwischenabschnitt 20 erweitert den Durchmesser des inneren Beckens 10 zu einem breiten Zylinder 19. Am oberen Rand des inneren Beckens 10 ist der Rand als schräge Außenkante 23 ausgebildet. Dies verbessert die Eigenschaften des oberen Randes des inneren Beckens 10 hinsichtlich des Überlaufens einer Flüssigkeit. Mittels Nivellierungsschrauben 4, die das innere Becken 10 an dem äußeren Becken 5 befestigen, und die in der Kammer 6 des äußeren Becken angeordnet sind, kann das innere Becken 10 ausgerichtet werden, um beispielsweise ein gleichmäßiges Überlaufen des Spülfluids über die gesamte Beckenlänge zu garantieren. Das innere Becken 10 weist an seinem Boden 11 zwei übereinander angeordnete Einleitvorrichtungen, nämlich einen Diffusor 25 und einen Einleitmechanismus 26 auf. Der Diffusor 25 ist oberhalb des Einleitmechanismus 26 angeordnet. Der Diffusor 25 steht über eine Zuleitung 30 mit einem Fluidbehälter 35 in Verbindung, der vorzugsweise Ozon (O₃) enthält. In der Zeichnung ist die Strömungsrichtung des Ozons durch einen Pfeil dargestellt. Der Einleitmechanismus 26 steht über eine Zuleitung 31 mit einer Pumpe 36 in Verbindung. Die Pumpe 36 pumpt fakultativ aus dem Fluidreservoir 37 bzw. 38 über die Leitungen 39 bzw. 40 ein Fluid zur chemischen Behandlung für den Wafer 2, wie zum Beispiel verdünnte Flußsäure. In der Fig. 1 stellt ein Pfeil die Richtung des Flusses des gepumpten Fluids in der Zuleitung 31 dar. Ebenfalls befinden sich im inneren Becken 10 rechte und linke Auflagevorrichtungen 43 bzw. 44, die in zwei Halterungen 46 bzw. 47 fixiert sind, die parallel in der Höhe im inneren Becken 10 verstellt werden können. Die rechten und linken Auflagevorrichtungen 43, 44 weisen einen kreisförmigen Ausschnitt 60 bzw. 61 auf zur Aufnahme des Wafers 2. In der Mitte zwischen den beiden Auflagevorrichtungen 43, 44 befindet sich ein sogenanntes Messer 42, d. h. ein langgestrecktes Element mit einer spitzen Kante. Das Messer 42 ist beispielsweise aus Quarzglas gefertigt und unabhängig von den rechten und linken Auflagevorrichtungen 43 bzw. 44 in der Höhe bewegbar. In Fig. 1 erkennt man, daß das Messer 42 den Wafer 2 aus dem inneren Becken 10 angehoben hat und der Wafer 2 von einer Halterung 51 oberhalb des inneren Beckens 10 in der Haube 12 gehalten wird. Die Führung oder Waferaufnahme 51 weist analog den Auflagevorrichtungen 43, 44 eine Rillenform auf, um gleichzeitig ein Vielzahl von Wafern ohne eine Kassette zu handhaben. Zum leichteren Einsetzen des Wafers 2 in die Führung 51 ist eine Innenkante 52 der Führung 51 abgeschrägt. Der bzw. die Wafer 2 wird bzw. werden von der Führung 51 gehalten bzw. geführt. Das äußere Becken 5 wird von einer Abdeckung 8, die eine Öffnung 9 aufweist, nach oben abgeschlossen. Das äußere Becken 5, das als Sicherheitsreservoir dient, besteht aus einem Schmalzylinder 48, der über einen Zwischenabschnitt 50, der als Scheibe mit einer zentralen kreisförmigen Öffnung ausgebildet ist, mit einem breiten Zylinder 49 verbunden ist. Der breite Zylinder 49 bildet die Außenseite der inneren ringförmigen Kammer 7 bzw. die Innenseite der äußeren ringförmigen Kammer 6 aus der das übergelaufene Fluid durch die Öffnung 9 abgeleitet bzw. abgepumpt werden kann.

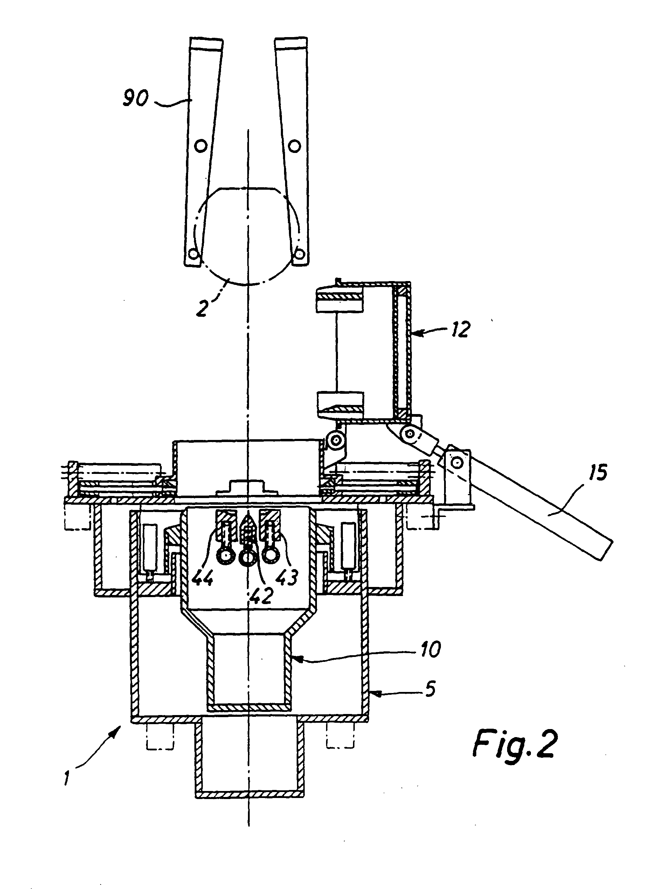

In Fig. 2 erkennt man den ersten Schritt eines Prozeßflusses, der in den Fig. 2 bis 9 dargestellt ist. In Fig. 2 erkennt man, daß ein Waferpaket, dargestellt durch den einen Wafer 2 von einem Anlagenhandler 90 der Vorrichtung zugeführt wird. Die Haube 12, die mit der Waferaufnahme 51 verbunden ist, wurde über den automatischen Zylinder 15 geöffnet. Das Messer 42 und die rechten und linken Auflagevorrichtungen 43 bzw. 44 sind bereit, den Wafer 2 aufzunehmen. Dazu befindet sich das Messer 42 etwas abgesenkt gegenüber den Auflagevorrichtungung 43, 44, so daß die Spitze des Messers 42 auf einer Kreislinie mit den kreisförmigen Ausschnitten 60 bzw. 61 liegt, auf der später der Wafer 2 aufliegt.

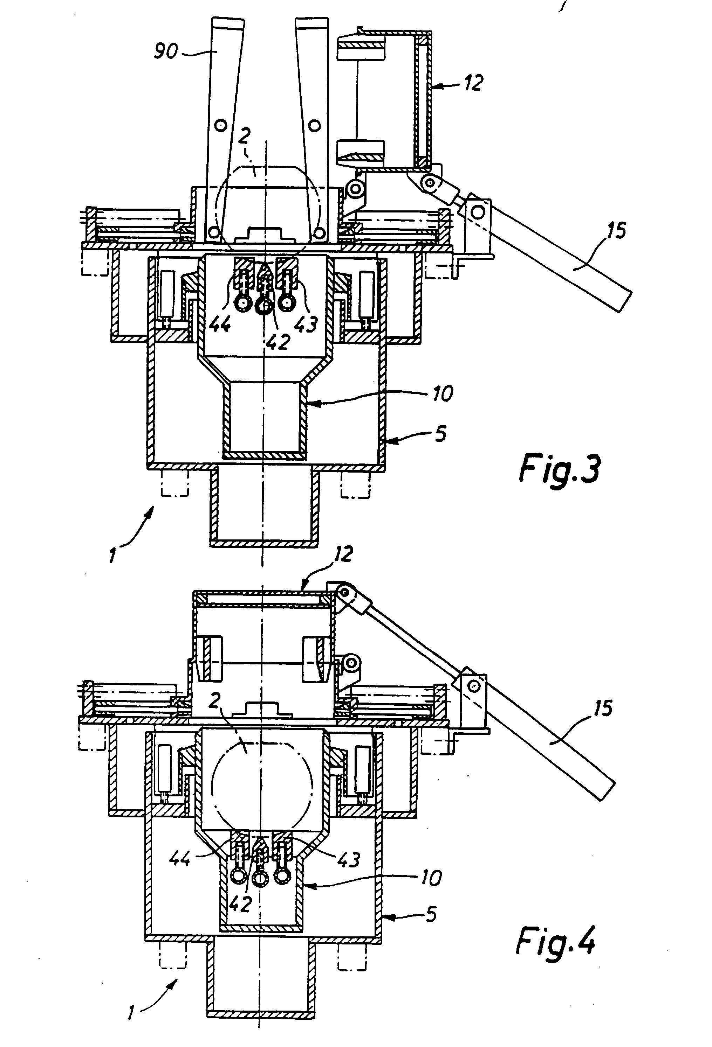

In Fig. 3 ist nun das Absetzen eines Wafers 2 in das innere Becken 10, das zum Beispiel mit HF gefüllt ist, dargestellt.

In Fig. 4 erkennt man, daß die Haube 12 über dem inneren Becken 10 geschlossen wird und der Wafer 2 in dem inneren Becken 10 abgesenkt wird, in eine untere Position etwa bis zum Zwischenabschnitt 20, wobei das Messer 42 und die rechten und linken Auflagevorrichtungen 43 bzw. 44 mit gleicher Geschwindigkeit nach unten fahren.

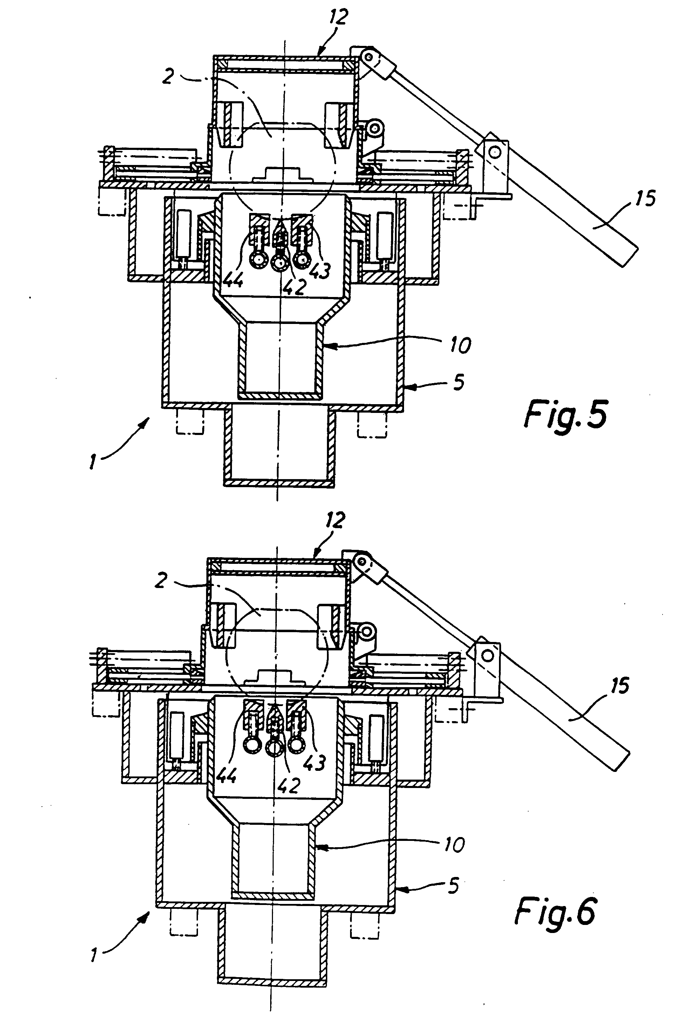

In Fig. 5 ist der Trocknungsschritt des Wafers 2 dargestellt, d. h. das Ausheben des Wafers 2 aus dem inneren Becken 10. Erfindungsgemäß wird zwischen den in Fig. 4 und 5 dargestellten Schritten das chemische Fluid HF durch ein anderes Fluid ersetzt, wobei zuletzt vorzugsweise ein Spülfluid eingeleitet wird. Vorzugsweise wird oberhalb des inneren Beckens 10 ein Dampf auf den Wafer angewendet, der nicht auf dem Wafer 2 kondensiert und wobei die Mischung zwischen Spülfluid und Dampf eine geringere Oberflächenspannung als das Spülfluid alleine besitzt. Zu diesem Zweck ist die Haube 12 immer noch geschlossen. Vorzugsweise fährt das Messer 42 mit einer konstanten Geschwindigkeit nach oben, die beiden Auflagevorrichtungen 43 und 44 aber nur mit halber Geschwindigkeit, weshalb sie zurückbleiben.

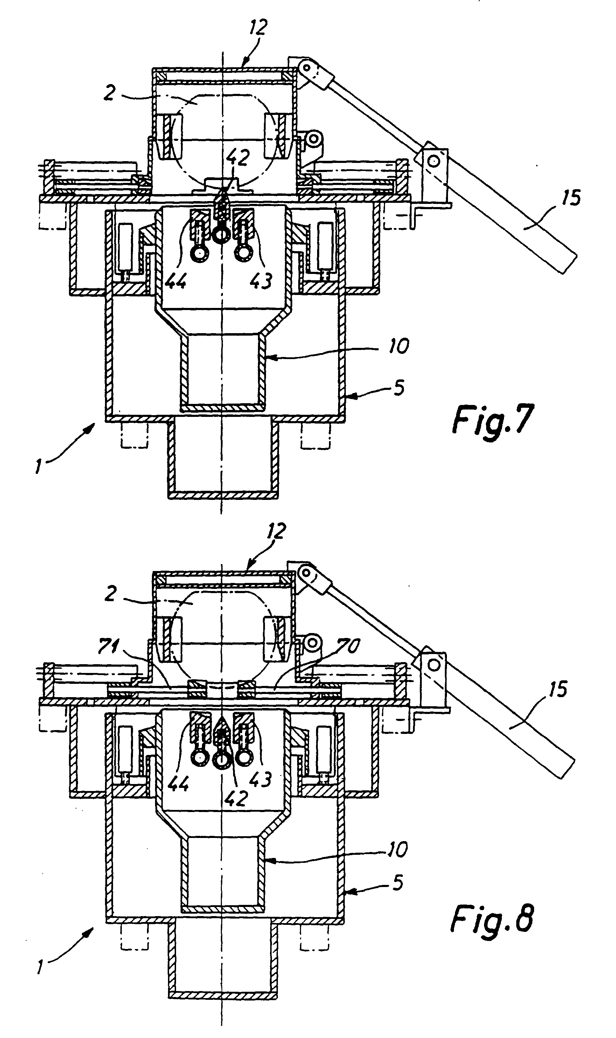

In Fig. 6 ist das Stehenbleiben der Auflagevorrichtung 43 und 44 dargestellt; ein weiteres Ausheben des Wafers 2 geschieht nur durch das Messer 42. Man erkennt, daß der Wafer 2 vor dem alleinigen Ausheben durch das Messer 42 noch in Kontakt mit dem Spülfluid im inneren Becken 10 steht.

In Fig. 7 ist das Ende des Trocknungsvorgangs dargestellt, d. h. der Wafer 2 ist vollständig aus dem inneren Becken 10 herausgehoben und wird von dem Messer 42 und der Halterung 51 gehalten.

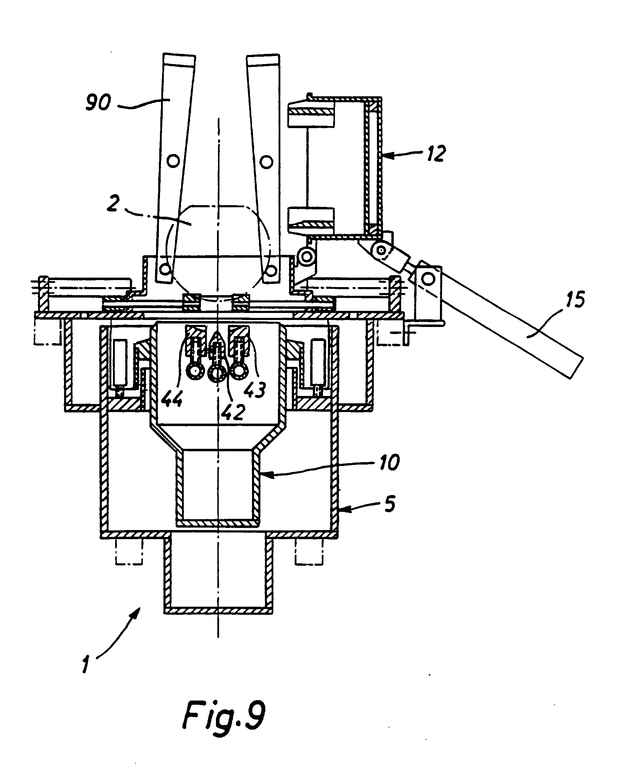

In Fig. 8 erkennt man, daß vor dem Öffnen der Haube 12 bewegliche Halterungen 70 und 71 in den Raum über dem inneren Becken 10 eingefahren werden, um den Wafer 2 während bzw. nach dem Öffnen der Haube 12, d.h. dem Entfernen der Halterung 51, von unten in seiner Position zu halten. Die Halterung des Wafers 2 kann alleine durch die bewegliche Halterungen 70 und 71 bewirkt werden, d. h. das Messer 42, die Auflagevorrichtungen 43, 44 und die Waferaufnahme 51 werden nicht zur weiteren Halterung des Wafers 2 benötigt. Die beweglichen Halterungen 70, 71 weisen kreisabschnittsförmige Einschnitte auf, um den Wafer 2 in seiner Lage zu halten. Ebenfalls ist in Fig. 8 erkennbar, daß das Messer 42 wieder in das innere Becken 10 eintaucht, und zwar in seine Ausgangsposition (vergleiche Fig. 2) unterhalb der rechten und linken Auflagevorrichtungen 43 und 44.

In Fig. 9 wird nun die Haube 12 geöffnet und der Anlagenhandler 90 entfernt den Wafer 2 aus der Vorrichtung 1 zur weiteren Verarbeitung. Die Fig. 2-9 stellen somit einen zyklischen Prozeß dar.

Die Erfindung wurde anhand bevorzugter Ausführungsbeispiele erläutert. Dem Fachmann sind jedoch zahlreiche Abwandlungen bzw. Ausgestaltungen möglich, ohne daß der Erfindungsgedanke verlassen wird.

## Patentansprüche

1. Verfahren zur chemischen Behandlung von Substraten bei dem
wenigstens ein Substrat (2) nacheinander einer chemischen Behandlung, einem Spülvorgang und einem Trocknungsvorgang nach dem Marangoni-Prinzip unterzogen wird; die chemische Behandlung und der Spülvorgang in demselben Becken (10) stattfinden; das Substrat (2) mittels einer Aufnahmevorrichtung, die ein Messer (42) und Auflagevorrichtungen (42,43) aufweist, im Becken (10) gehalten wird; der Trocknungsvorgang durch langsames Herausfahren des Substrats (2) mittels des Messers (42) aus dem Becken (10) geschieht;
das Substrat beim Herausfahren aus dem Becken in Führungen (51) einer für eine Dampfatmosphere im Bereich oberhalb des Beckens sorgende Haube (12) gehalten wird, wobei die Führungen an gegenüberliegenden Seiten der Haube vorgesehen sind, und die Haube geöffnet werden kann; und
seitlich bewegliche Halterungen (70,71) unterhalb oder in der Haube und oberhalb des Beckens, nach dem Herausfahren des Substrats, über das Becken von außen eingefahren und unter dieses bewegt werden und es in seiner Lage halten.

2. Verfahren nach Anspruch 1, **dadurch gekennzeichnet, daß** ein Ersetzen des Fluids zur chemischen Behandlung durch ein weiteres derartige Fluid und/oder das Spülfluid durch Verdrängen geschieht.

3. Verfahren nach einem der vorhergehenden Ansprüche, **dadurch gekennzeichnet, daß** das Spülfluid in das Becken (10) eingeleitet wird und das Gemisch aus Fluids zur chemischen Behandlung bzw. aus Fluid zur chemischen Behandlung und Spülfluid gleichzeitig abgeleitet wird.

4. Verfahren nach Anspruch 3, **dadurch gekennzeichnet, daß** das Einleiten des weiteren Fluids bzw. des Spülfluids und das Ableiten des Fluids zur chemischen Behandlung an verschiedenen Stellen des Beckens (10) erfolgt.

5. Verfahren nach Anspruch 3 oder 4, **dadurch gekennzeichnet, daß** das Einleiten des weiteren Fluids bzw. des Spülfluids vom Boden des Beckens (10) erfolgt.

6. Verfahren nach einem der Ansprüche 3 bis 5, **dadurch gekennzeichnet, daß** das Ableiten des Gemisches durch Überlaufen erfolgt.

7. Verfahren nach einem der vorhergehenden Ansprüche, **dadurch gekennzeichnet, daß** das Fluid zur chemischen Behandlung verdünnte Flußsäure ist.

8. Verfahren nach einem der vorhergehenden Ansprüche, **dadurch gekennzeichnet, daß** das Fluid zur chemischen Behandlung Ozon ist.

9. Verfahren nach einem der vorhergehenden Ansprüche, **dadurch gekennzeichnet, daß** der Spülvorgang durch eine Behandlung mit Megaschall unterstützt wird.

10. Vorrichtung zur Durchführung des Verfahrens nach einem der vorhergehenden Ansprüche mit
einer Einleitvorrichtung (25,30,31,35,36,37,38,40,49) für das Fluid für die chemische Behandlung und für den Spülvorgang in das Becken;
einer Ableitvorrichtung (7,23) für den Fluid aus dem Becken;
einer Aufnahmevorrichtung mit einem Messer (42) und Auflagevorrichtungen (43,44);
einer Bedampfungsanlage oberhalb des Beckens;
einer Haube (12) über dem Becken und der Bedampfungsanlage, die geöffnet werden kann, mit Führungen, die an gegenüberliegenden Seiten der Haube vorgesehen sind, zur Halterung des Substrats beim Herausfahren aus dem Becken; und
seitlich beweglichen Halterungen (70,71) unterhalb der Haube und oberhalb des Beckens, die über das Becken von außen einfahrbar sind und nach dem Herausfahren des Substrats unter dieses bewegt werden und es in seiner Lage halten können.

11. Vorrichtung (1) nach Anspruch 10, **dadurch gekennzeichnet, daß** die Ableitvorrichtung (7, 23) eine Überlaufvorrichtung (23) aufweist.

12. Vorrichtung (1) nach Anspruch 10 oder 11, **dadurch gekennzeichnet, daß** ein äußeres Becken vorgesehen ist.

13. Vorrichtung (1) nach einem der Ansprüche 10 bis 12, **dadurch gekennzeichnet, daß** die Vorrichtung Nivellierungsschrauben aufweist, um das Becken auszurichten.

14. Vorrichtung (1) nach einem der Ansprüche 10 bis 13, **dadurch gekennzeichnet, daß** die Einleitvorrichtung (25, 30, 31, 35, 36, 37, 38, 49, 40) einen Diffusor (25) aufweist.

15. Vorrichtung (1) nach einem der Ansprüche 10 bis 14, **dadurch gekennzeichnet, daß** die Einleitvorrichtung (25, 30, 31, 35, 36, 37, 38, 49, 40) eine Pumpe (36) mit einem Einleitmechanismus (26) aufweist.

16. Vorrichtung (1) nach einem der Ansprüche 10 bis 15, **dadurch gekennzeichnet, daß** mindestens ein Teil der Führung (51) eine abgeschrägte Kante (52) besitzt.

17. Vorrichtung (1) nach einem der Ansprüche 10 bis 16, **dadurch gekennzeichnet, daß** Mittel zur Behandlung mit Megaschall vorgesehen sind.

## Claims

1. Method for chemically treating substrates, in which at least one substrate (2) is subjected sequentially to a chemical treatment, a washing treatment and a drying treatment according to the Marangoni principle; the chemical treatment and the washing treatment are carried out in the same reservoir (10); the substrate (2) is held in the reservoir (10) by means of receiving device comprising a blade (42) and supports (42, 43); the drying treatment is carried out by slowly removing the substrate from the reservoir (10) by means of the blade (42); the substrate on removal from the reservoir is held in guides (15) of a hood (12) providing for a vapour atmosphere in the region above the reservoir, wherein the guides are provided at opposite sides of the hood, and the hood can be opened; and laterally movable guides (70, 71) below or in the hood and above the reservoir are after removal of the substrate driven in from outside over the reservoir and moved under this and keep it in its position.

2. Method according to claim 1, **characterised in that** a replacement of the fluid for chemical treatment by another such fluid and/or the washing fluid is carried out by displacement.

3. Method according to any one of the preceding claims, **characterised in that** the washing fluid is introduced into the reservoir (10) and the mixture of fluids for chemical treatment or of fluid for chemical treatment and washing fluid are drained simultaneously.

4. Method according to claim 3, **characterised in that** the introduction of the further fluid or of the washing fluid and the drainage of the fluid for chemical treatment take place at different locations of the reservoir (10).

5. Method according to claim 3 or 4, **characterised in that** the introduction of the further fluid or of the washing fluid takes place at the bottom of the reservoir (10).

6. Method according to any one of claims 3 to 5, **characterised in that** the drainage of the mixture takes place by overflow.

7. Method according to any one of the preceding claims, **characterised in that** the fluid for chemical treatment is diluted hydrofluoric acid.

8. Method according to any one of the preceding claims, **characterised in that** the fluid for chemical treatment is ozone.

9. Method according to any one of the preceding claims, **characterised in that** the washing process is enhanced by treatment with mega sound.

10. Device for performing the method according to any one of the preceding claims, with a device (25, 30, 31, 35, 36, 37, 38, 40, 49) for introduction of the fluid for the chemical treatment and for the washing process into the reservoir; a device (7, 23) for draining the fluid from the reservoir; a receiving device with a blade (42) and supports (43, 44); a vaporising device above the reservoir; a hood (12) above the reservoir and the vaporising device, which hood can be openable, with guides provided at opposite sides of the hood for holding the substrate on removal from the reservoir; and laterally movable guides (70, 71) below the hood and above the reservoir, which can be driven in from the outside over the reservoir and after removal of the substrate are moved under this and can keep it in position.

11. Device (1) according to claim 10, **characterised in that** the device (7, 23) for draining comprises an overflow device (23).

12. Device (1) according to claim 10 or 11, **characterised in that** an outer reservoir is provided.

13. Device (1) according to any one of claims 10 to 12, **characterised in that** the device has levelling screws in order to level the reservoir.

14. Device (1) according to any one of claims 10 to 13, **characterised in that** the device (25, 30, 31, 35, 36, 37, 38, 49, 40) for introducing comprises a diffusor (25).

15. Device (1) according to any one of claims 10 to 14, **characterised in that** the device (25, 30, 31, 35, 36, 37, 38, 49, 40) for introducing comprises a pump (36) with an insertion mechanism (26).

16. Device (1) according to any one of claims 10 to 15, **characterised in that** at least a part of the guide (51) has a slanted edge (52).

17. Device (1) according to any one of claims 10 to 16, **characterised in that** means for treating with mega sound are provided.

## Revendications

1. Procédé pour le traitement chimique de substrats, dans lequel au moins un substrat (2) est soumis successivement à un traitement chimique, une opération de rinçage et une opération de séchage selon le principe de Marangoni ;où le traitement chimique et l'opération de rinçage ont lieu dans le même bassin (10) ; où le substrat (2) est tenu dans le bassin (10) au moyen d'un dispositif de réception qui présente une lame (42) et des dispositifs d'appui (43, 44) ; où l'opération de séchage a lieu par une sortie lente du substrat (2) au moyen de la lame (42) du bassin (10) ; où le substrat, lors de la sortie du bassin, est tenu dans des guidages (51) d'un capot (12) assurant une atmosphère de vapeur dans la zone au-dessus du bassin, où les guidages sont prévus aux côtés opposés du capot et le capot peut être ouvert ; et où des fixations latérales mobiles (70, 71) en dessous ou dans le capot et au-dessus du bassin, après la sortie du substrat, sont rentrées sur le bassin depuis l'extérieur et sont amenées sous celui-ci et le maintiennent dans sa position.

2. Procédé selon la revendication 1, **caractérisé en ce qu'**un remplacement du fluide pour le traitement chimique par un tel autre fluide et/ou le fluide de rinçage a lieu par refoulement:

3. Procédé selon l'une des revendications précédentes, **caractérisé en ce que** le fluide de rinçage est introduit dans le bassin (10) et que le mélange constitué du fluide pour le traitement chimique respectivement du fluide pour le traitement chimique et le fluide de rinçage est évacué simultanément.

4. Procédé selon la revendication 3, **caractérisé en ce que** l'introduction du fluide supplémentaire respectivement du fluide de rinçage et l'évacuation du fluide pour le traitement chimique a lieu à des emplacements différents du bassin (10).

5. Procédé selon la revendication 3 ou 4, **caractérisé en ce que** l'introduction du fluide supplémentaire respectivement du fluide de rinçage a lieu au fond du bassin (10).

6. Procédé selon l'une des revendications 3 à 5, **caractérisé en ce que** l'évacuation du mélange a lieu par débordement.

7. Procédé selon l'une des revendications précédentes, **caractérisé en ce que** le fluide pour le traitement chimique est de l'acide fluorhydrique dilué.

8. Procédé selon l'une des revendications précédentes, **caractérisé en ce que** le fluide pour le traitement chimique est de l'ozone.

9. Procédé selon l'une des revendications précédentes, **caractérisé en ce que** l'opération de rinçage est soutenue par un traitement avec des mégasons.

10. Dispositif pour la mise en oeuvre du procédé selon l'une des revendications précédentes, avec un dispositif d'introduction (25, 30, 31, 35, 36, 37, 38, 40, 49) pour le fluide pour le traitement chimique et pour l'opération de rinçage dans le bassin ; un dispositif d'évacuation (7, 23) pour le fluide du bassin ; un dispositif de réception avec une lame (42) et des dispositifs d'appui (43, 44) ; une installation de vaporisation au-dessus du bassin ; un capot (12) au-deasus du bassin et de l'installation de vaporisation, qui peut être ouvert, avec des guidages qui sont prévue à des côtés opposés du capot, pour tenir le substrat lors de la sortie du bassin ; et des fixations latérales mobiles (70, 71) en dessous du capot et au-dessus du bassin, qui peuvent être rentrées sur le bassin depuis l'extérieur et qui, après la sortie du substrat, sont amenées sous celui-ci et peuvent le maintenir dans sa position.

11. Dispositif (1) selon la revendication 10, **caractérisé en ce que** le dispositif d'évacuation (7, 23) présente un dispositif de débordement (23).

12. Dispositif (1) selon l'une des revendications 10 ou 11, **caractérisé en ce qu'**il est prévu un bassin extérieur.

13. Dispositif (1) selon l'une des revendications 10 à 12, **caractérisé en ce que** le dispositif présente des vis de niveau pour ajuster le bassin.

14. Dispositif (1) selon l'une des revendications 10 à 13, **caractérisé en ce que** le dispositif d'introduction (25, 30, 31, 35, 36, 37, 38, 49, 40) présente un diffuseur (25).

15. Dispositif (1) selon l'une des revendications 10 à 14, **caractérisé en ce que** le dispositif d'introduction (25, 30, 31, 35, 36, 37, 38, 49, 40) présenté une pompe (36) avec un mécanisme d'introduction (26).

16. Dispositif (1) selon l'une des revendications 10 à 15, **caractérisé en ce qu'**au moins une partie du guidage (51) présente une arête chanfreinée (52).

17. Dispositif (1) selon l'une des revendications 10 à 16, **caractérisé en ce que** des moyens pour le traitement avec des mégasons sont prévus.
